# EUROPÄISCHE PATENTANMELDUNG

(11) **EP 0 838 900 A1**
(43) Veröffentlichungstag der Anmeldung: **29.04.1998**
(21) Anmeldenummer: 97116896.8
(22) Anmeldetag: 29.09.1997
(51) Int. Cl.: H03L 7/12

(54) **Phasenregelschleife mit Frequenzregelung als Fanghilfe**

(30) Priorität: 25.10.1996 DE 19644459
(71) Anmelder: SIEMENS AKTIENGESELLSCHAFT, 80333 München (DE)
(72) Erfinder: Zirwas, Wolfgang, 82194 Gröbenzell (DE)

(57) **Zusammenfassung**

Bei Phasenregelschleifen für hohe Frequenzen im Bereich von 20 bis 40 Gbit/s besteht das Problem, daß der Fangbereich der Phasenregelschleife nur wenige MHz umfassen kann, während die Frequenzablage des verwendeten spannungsgesteuerten Oszillators bis zu 200 MHz betragen kann. Es ist also eine zusätzliche Fanghilfe notwendig, die erfindungsgemäß darauf beruht, daß der spannungsgesteuerte Oszillator der Phasenregelschleife gezielt verstimmt wird und dabei geprüft wird, ob sich die Differenzfrequenz zwischen der Frequenz der Eingangssignale und der Frequenz des Ausgangssignals des spannungsgesteuerten Oszillators erhöht oder erniedrigt.

## Beschreibung

Die Erfindung betrifft ein Verfahren zur Frequenzregelung entsprechend dem Oberbegriff des Anspruchs 1 und eine Anordnung zur Durchführung des Verfahrens.

Phasenregelschleifen sind in verschiedenen Modifikationen aus M.Gardner "Phaselock Techniques" 2nd Edition, 1979 by John Wiley & Sons, Inc., ISBN 0-471-04294-3 bekannt. Zur Takt- und Datenregeneration im Bereich von 20 bis 40 Gbit/s ist in der älteren Anmeldung DE 195 23 185.6 ein Autokorrelationsverfahren beschrieben. Bei der sich ergebenden Dimensionierung hinsichtlich der Steilheit des Phasendiskriminators, dem Dämpfungsverlauf des Schleifenfilters und der Steilheit des spannungsgesteuerten Oszillators der Phasenregelschleife ist der Fangbereich derartiger Phasenregelschleifen häufig nur wenige MHz. Insbesondere beim Einschalten oder nach Störungen kann die Frequenzablage des in der Phasenregelschleife verwendeten spannungsgesteuerten Oszillator aber bis zu etwa 200 MHz betragen, so daß eine zusätzliche Fanghilfe benötigt wird.

In der älteren deutschen Anmeldung 195 23 186.4 ist eine Möglichkeit für eine Fanghilfe beschrieben, bei der eine kombinierte Frequenz- und Phasenregelschleife eine zusätzliche Vergleicherstufe enthält, in der die Differenz zwischen einer Referenzspannung und dem Ausgangssignal des Tiefpaßfilters der Phasenregelschleife gebildet wird. Die so erzeugte Differenzspannung wird an den Eingang des spannungsgesteuerten Oszillators der Phasenregelschleife abgegeben. Ob bei dieser Lösung die Phasenregelschleife fängt oder nicht, kann bei ungünstiger Dimensionierung von den Anfangsbedingungen wie momentaner Phase, Frequenz des spannungsgesteuerten Oszillators oder Verstellgeschwindigkeit der Regelspannung abhängen, da bei zu hoher Verstellgeschwindigkeit der Fangbereich der Regelschleife bereits wieder verlassen wird, bevor die Phasenregelschleife gefangen hat. Bei dieser Lösung ist also eine sehr sorgfältige Dimensionierung der Phasenregelschleife notwendig, es müssen mögliche Variationen der Phasendetektorsteilheit, der Steilheit des spannungsgesteuerten Oszillators der Phasenregelschleife abhängig von Exemplarstreuung, Alterung, Temperatur für die Eingangsdaten mitberücksichtigt werden.

Damit eine Phasenregelschleife möglichst stabil arbeitet, sollte der Offset am Phasendiskriminator möglichst klein und am besten gleich null sein. Bei der eingangs erwähnten Lösung wird dagegen für die Fanghilfe ohne weiteren Zusatzmaßnahmen ein konstanter Offset benötigt. Dieser Offset muß dann relativ groß gewählt werden damit er auch bei Temperatur- und Spannungsschwankungen nicht verschwindet.

Die Aufgabe bei der vorliegenden Erfindung besteht also darin, das Verfahren und die Anordnung der eingangs erwähnten Art so weiterzuentwickeln, daß am Phasendiskriminator im gefangenen Zustand ein möglichst kleiner Offset auftritt.

Die Aufgabe wird erfindungsgemäß durch ein Verfahren gelöst, das durch die Merkmale des Patentanspruchs 1 weitergebildet ist und durch eine Vorrichtung entsprechend Anspruch 5. Die vorliegende Erfindung erlaubt ein schnelles und sicheres Fangen für spannungsgesteuerte Oszillatoren mit großem Regelbereich und kleinem Fangbereich. Die Erfindung verhindert, daß sich der spannungsgesteuerte Oszillator bei speziellen Datensignalen bei denen er sehr hohe Nebenlinien aufweist und unter ungünstigen Umständen auf eine Nebenlinie statt auf seine eigentliche Mittenfrequenz synchronisiert.

Die Erfindung soll im folgenden anhand eines in der Zeichnung dargestellten Ausführungsbeispiels näher erläutert werden. Dabei zeigt:

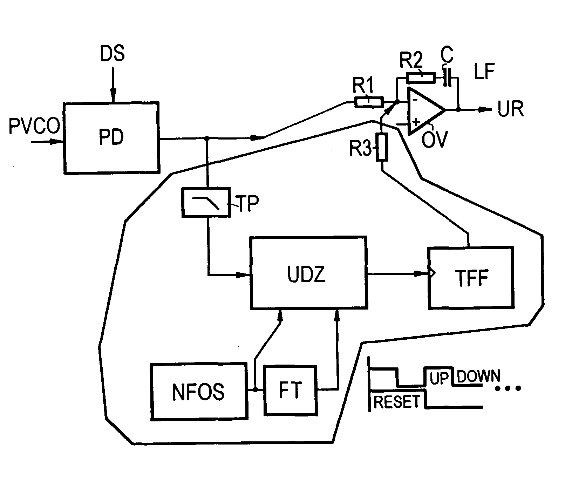

Die Figur 1 das Prinzipschaltbild für die erfindungsgemäße Fanghilfe.

In der Figur 1 ist ein Phasendiskriminator PD vorgesehen, dessen Eingang DS für das Datensignal dem Eingang der Phasenregelschleife entspricht und der zusätzlich einen Eingang PVCO aufweist, an den der Ausgang des in der Figur 1 nicht dargestellten spannungsgesteuerten Oszillators VCO der Phasenregelschleife angeschlossen ist. Der Ausgang des Phasendiskriminators PD ist über einen Tiefpaß TP mit dem Eingang eines Up/Down-Zählers UDZ und außerdem über ein aktives Schleifenfilter LF mit dem Regelspannungseingang UR des spannungsgesteuerten Oszillators VCO verbunden. Das aktive Schleifenfilter LF enthält einen Operationsverstärker OV, dessen invertierender Eingang über einen ersten Widerstand R1 an den Ausgang des Phasendiskriminators PD angeschlossen ist, außerdem ist der Ausgang des Operationsverstärkers OV über die Reihenschaltung eines Kondensators C und eines zweiten Widerstandes R2 auf den invertierenden Eingang des Operationsverstärkers OV rückgekoppelt. Die Anordnung nach der Figur 1 enthält zusätzlich einen NF-Oszillator mit einer Schwingfrequenz von etwa 10 kHz, dessen Ausgangssignal direkt auf den Zähleingang UD des Zählers UDZ sowie über einen Frequenzteiler FT mit einem Teilerverhältnis von 2:1 auf den Rücksetzeingang RS des Zählers UDZ geführt ist. Der Ausgang AZ des Zählers UDZ ist mit dem auslösendem Eingang eines Toggle-Flipflop TFF verbunden, dessen Ausgang über einen dritten Widerstand R3 mit dem invertierenden Eingang des Operationsverstärkers OV verbunden ist.

Am Ausgang des Phasendetektors BD entsteht im umgefangenen Zustand ein auch als Beetnote bezeichnetes Wechselsignal, dessen Frequenz der Differenzfrequenz zwischen der Frequenz der Eingangsdaten und der Frequenz des spannungsgesteuerten Oszillators VCO der Phasenregelschleife entspricht. Dabei ist zunächst unklar, ob die Frequenz des spannungsgesteuerten Oszillators VCO zu groß oder zu klein ist. Dies läßt sich klären, wenn entsprechend der Erfindung die Regelspannung des spannungsgesteuerten Oszillators VCO gezielt verstimmt und gleichzeitig geprüft wird, ob die sogenannte Beetnotefrequenz größer oder kleiner wird. Steigt diese Frequenz, muß die Richtung der Verstimmung umgedreht werden. Dieser Fall kann nur einmal auftreten, danach wird der spannungsgesteuerte Oszillator solange verstimmt, bis der Fangbereich der Phasenregelschleife erreicht ist und diese fängt. Die Frequenzmessung erfolgt mit dem Up/Down-Zähler UDZ, der über den Tiefpaß TP mit einer Grenzfrequenz oberhalb der maximalen Differenz zwischen der Frequenz des spannungsgesteuerten Oszillators und der Frequenz der Datensignale liegt. Die für den Zähler UDZ benötigten Steuersignale werden dabei vom NF-Oszillator NFOS mit nachgeschaltetem Frequenzteiler erzeugt, wobei mit dem Signal Reset der UDZ zunächst zurückgesetzt wird. Dann arbeitet der Zähler UDZ als Aufwärtszähler, da das Signal an dessen UD-Eingang auf dem H-Pegel liegt. Nach Erreichen des maximalen Zählergebnisses wird die Zählrichtung im Zähler UDZ umgekehrt, das Signal am Up/Down-Eingang UD ist dann auf dem Low-Pegel. Die Phasen für die beiden Zählrichtungen sind exakt gleich lang. Bei einer konstanten Frequenz der Beetnote ist das Ergebnis am Ende eines Meßzyklusses deshalb gleich Null. Wird die Frequenz der Beetnote während der Down-Phase kleiner, da die Differenz der Frequenzen zwischen dem Ausgangssignal des spannungsgesteuerten Oszillators und dem Datensignal abgenommen hat, ist das Zählergebnis positiv. Nur wenn der spannungsgesteuerte Oszillator VCO von der Sollfrequenz weggeregelt wird, ist die Frequenz der Beetnote in der "Down-Phase" größer als in der "Up-Phase". Dann tritt am Zähler UZ ein Ausgangssignal auf, das über das Toggle-Flip-flop TFF die Beetrichtung, also die Richtung der Veränderung der Regelspannung des spannungsgesteuerten Oszillator, umschaltet.

Bei der beschriebenen Ausführung ist besonders vorteilhaft, daß am Ausgang des Zählers UDZ der Fangzustand festgestellt werden kann, der Zählerausgang also als sogenannter Lock-In-Detektor verwendet werden kann. Im gefangenen Zustand ist das Ausgangssignal am Zähler UZ konstant auf dem Nullpegel. Eine in der Zeichnung nicht dargestellte Verfeinerung der Schaltung ist dadurch möglich, daß man die Geschwindigkeit der Veränderung der Regelspannung des spannungsgesteuerten Oszillators abhängig von der Höhe der Frequenz der Beetnote regelt. Bei hoher Frequenz der Beetnote wird also auch der spannungsgesteuerte Oszillator VCO sehr schnell geregelt, bei kleinerer Frequenz wird die Regelgeschwindigkeit entsprechend verkleinert. Dadurch ist es möglich, einerseits bei sehr großen Frequenzablagen ein sehr schnelles Fangen sicherzustellen und andererseits durch die langsamere Regelung in der Nähe des Fangbereichs das Fangen zu stabilisieren. Sollte der Fangbereich trotzdem durchfahren werden, wird die Sweeprichtung des spannungsgesteuerten Oszillators am Ende des Fangbereichs sofort wieder umgekehrt, so daß eine gezielte Veränderung der Regelspannung des spannungsgesteuerten Oszillators in Richtung auf ein positives Fangergebnis erreicht wird.

Bei einer Weiterbildung der erfindungsgemäßen Fanghilfe wird der Frequenzzähler möglichst differentiell und über einen Schmitt-Trigger mit ausreichender Hysterese angesteuert, damit der Frequenzzähler nicht auf Störungen im Phasendetektor-Ausgangssignal anspricht.

## Patentansprüche

1. Verfahren zur Frequenzregelung als Fanghilfe in einer Phasenregelschleife, bei dem von einem Phasendiskriminator ein Ausgangssignal mit einer Frequenz erzeugt wird, die die Differenzfrequenz zwischen der Frequenz der Eingangssignale der Phasenregelschleife und der Frequenz der von einem in der Phasenregelschleife enthaltenen spannungsgesteuerten Oszillator erzeugten Schwingung ist,
**dadurch gekennzeichnet,**
daß der spannungsgesteuerte Oszillator (VCO) gezielt verstimmt wird und dabei geprüft wird, ob sich die Differenzfrequenz erhöht oder erniedrigt und daß bei steigender Differenzfrequenz die Richtung der Verstimmung umgekehrt wird.

2. Verfahren nach Anspruch 1,
**dadurch gekennzeichnet,**
daß die Verstimmung des spannungsgesteuerten Oszillators (VCO) durch Veränderung von dessen Regelspannung herbeigeführt wird.

3. Verfahren nach Ansprüchen 1 oder 2,
**dadurch gekennzeichnet,**
daß die Geschwindigkeit der Verstimmung für den spannungsgesteuerten Oszillator (VCO) in Abhängigkeit von der Höhe der Differenzfrequenz geregelt wird.

4. Verfahren nach Ansprüchen 1 bis 3,
**dadurch gekennzeichnet,**
daß beim Überschreiten der Fanggrenze der Phasenregelschleife die Richtung der Verstimmung umgekehrt wird.

5. Phasenregelschleife mit einem Phasendiskriminator, an dessen Ausgang über ein Schleifenfilter der Regeleingang eines spannungsgesteuerten Oszillators angeschlossen ist, daß dessen einer Signalausgang mit einem zugeordneten Eingang des Phasendiskriminators verbunden ist, während dessen anderer Eingang mit dem Eingang der Phasenregelschleife für das Datensignal verbunden ist,
**dadurch gekennzeichnet,**
daß mit dem Ausgang des Phasendetektors (PD) über einen Tiefpaß ein Eingang eines Up/Down-Zählers (UDZ) verbunden ist, dessen Ausgang über ein Toggle-Flip-Flop (TFF) mit einem Eingang des Schleifenfilters LF verbunden ist, daß ein NF-Oszillator (NFOS) vorgesehen ist, dessen Ausgang direkt mit einem Zähleingang des Up/Down-Zählers (UDZ) sowie über einen Frequenzteiler (FT) mit einer Teilerrate von 2:1 mit einem Reset-Eingang des Up/Down-Zählers (UDZ) verbunden ist.

6. Phasenregelschleife nach Anspruch 5,
**dadurch gekennzeichnet,**
daß nach dem Einschalten zunächst der Reset-Eingang des Up/Down-Zähler (UDZ) aktiv ist und dadurch der Zähler zurückgesetzt wird und danach als Aufwärtszähler fungiert, daß nach Überschreiten der Fanggrenze der Phasenregelschleife die Zählrichtung umgekehrt wird und daß die Phasen für das Aufund Abwärtszählen exakt gleich lang sind.
